# EUROPEAN PATENT APPLICATION

(11) **EP 2 560 468 A1**
(43) Date of publication of application: **20.02.2013**
(21) Application number: 11178151.4
(22) Date of filing: 19.08.2011
(51) Int. Cl.: H05K 3/32

(54) **Method of connecting elements of a plurality of elements to one another**

(71) Applicant: ABB Research Ltd., 8050 Zürich (CH)
(72) Inventor: Liu, Chunlei, 8051 Zürich (CH); Schulz, Nicola, 5300 Turgi (CH); Kicin, Slavo, 8049 Zürich (CH)
(74) Representative: ABB Patent Attorneys

(57) **Abstract**

A method of connecting elements (102-106) of a plurality of elements (102-106) to one another is described. The method comprises applying solder material (110) on a first element (102) of the plurality of elements (102-106). The solder material (110) comprises a liquidus temperature. The method comprises applying sinter material (108) on a second element (103) of the plurality of elements (102-104). The sinter material (108) comprises a sintering temperature. The method comprises assembling the first element (102) and a third element (104, 504) of the plurality of elements (102-106), assembling the second element (103) and a fourth element (106) of the plurality of elements (102-106), soldering the first element (102) and the third element (104) to one another, and sintering the second element (103) and the fourth element (106) to one another. In order to accomplish short process duration, reduced costs and an increased throughput, the sintering and the soldering are simultaneously executed.

## Description

### Technical Field

The invention relates to electronic packaging and in particular to a method of connecting elements of a plurality of elements to one another.

### Background Art

Various techniques are known for connecting elements comprising at least a metallic surface to one another.

One of these techniques is based on soldering a first element and a second element to one another using solder material such as a solder preform or a solder paste. In a respective soldering process, the solder material is applied on one of the first and second elements. Next, the first and second elements are assembled, and the first and second elements are heated above a liquidus temperature of the solder material. Next, the first and second elements are cooled down to room temperature such that a mechanically stable, thermally and electrically conductive connection of the first and second elements via a formed solder layer is accomplished. The liquidus temperature of the solder material may depend on the composition of the solder material, and may comprise values above about 180 degree Celcius (°C) or even above about 300°C. Soldering first and second elements to one another is usually used in a case in which at least one of the first and second elements to be connected to one another may comprise an uneven surface.

Another connecting technique employs (pressure based) sintering, in particular low temperature bonding (LTB), using a sinter material such as a sinter paste. Usually, the sinter material comprises metallic particles of nanometer or micrometer scale which are dispersed in a carrier material (for example, organic solvents, fatty acids, fish oil). In a respective sintering process, the sinter material is applied on one of the first and second elements. Next, the first and second elements are assembled, and the first and second elements are heated to a drying temperature of the sinter material. Accordingly, the sinter material is dried for some time at the drying temperature such that e.g. a solvent or a water amount of the sinter material is removed. Next, pressure is applied to those surfaces of the first and second elements which are not in contact with the sinter material. Simultaneously, the first and second elements are heated to a sintering temperature such that the sinter material is activated and the metallic particles of the sinter material are condensed and/or may diffuse into adjacent surface layers of the assembled first and second elements. Here, a presence of oxygen in the process atmosphere is required. Next, the first and second elements are cooled down to room temperature and the pressure is released. The first and second elements are then connected to one another via a sinter bonding layer being formed by the cured sinter material and being electrically and thermally conductive. Sintering may be used for connecting elements to one another which may comprise plane and parallel surfaces.

Soldering and sintering are usually used in conjunction with electronic packaging during which process semiconductor dies and/or semiconductor based electronic components (for example, transistors) may be bonded to a carrier substrate (for example, a printed circuit board).

DE 102 44 748 A1 describes a semiconductor power module which comprises a baseplate and a plurality of insulated gate bipolar transistors (IGBT) chips which are connected to the baseplate via a lower surface thereof. Further, metal wires are connected to upper surfaces of the IGBT chips. A connection between the metal wires and the upper surfaces of the IGBT chips and a connection between the lower surfaces of the IGBT chips and the baseplate are accomplished either by soldering or low temperature bonding.

US 4,810,672 describes a sintering process for securing electronic components to a substrate. A used sinter material is configured as a silver paste comprising particles of micrometer scale. A respective sintering temperature may comprise values between 180°C and 250°C, and a mechanical pressure to be applied comprises a value of at least 900 Newton per square centimeters (N/ cm²).

WO 2005/079353 A2 describes a method of interconnecting electrical components to a wafer using low temperature sintering. A used sinter material is configured as a metal paste comprising metal particles of nanometer scale.

Various electronic components may have to be connected to one another by either sintering or soldering during electronic packaging of an electronic device. For example, in an electronic device, semiconductor based components may have to be sintered to a carrier substrate, and the carrier substrate may have to be soldered to a printed circuit board.

In order to prevent (for example, temperature induced) damages of the elements involved in the electronic packaging process, the sintering and soldering processes have to be strictly separated, and are thus executed separately.

However, a total assembling duration of the elements of the electronic device may be long owing to the separation of the different connection processes, whereby manufacturing costs are significantly increased.

Further, a throughput of the packaging process may be low.

### Summary of invention

It may be an object of the present invention to provide an improved method of connecting elements to one another which may particularly comprise short process duration, low costs and high throughput.

The object defined above is solved by a method of connecting elements of a plurality of elements to one another according to the independent claim.

According to an exemplary aspect of the invention, a method of connecting elements of a plurality of elements to one another is provided, the method comprising applying solder material on a first element of the plurality of elements, wherein the solder material comprises a liquidus temperature, applying sinter material on a second element of the plurality of elements, wherein the sinter material comprises a sintering temperature, assembling the first element and a third element of the plurality of elements, assembling the second element and a fourth element of the plurality of elements, soldering the first element and the third element to one another, and sintering the second element and the fourth element to one another, wherein the sintering and the soldering are simultaneously executed.

An electronic device manufactured by the above described method may comprise first, second, third, and fourth elements, wherein the first element is connected to the third element via a solder layer (particularly a layer formed by soldering) and the second element is connected to a fourth element via a sinter layer (particularly a layer formed by sintering, particularly low temperature bonding (LTB)).

The term "liquidus temperature" of a solder material may particularly denote a temperature value or a temperature range at which crystals formed in the solder material may co-exist with melted material portions in a thermal dynamic equilibrium. In particular, crystallization of the solder material may start below the liquidus temperature, and the solder material may be melted above the liquidus temperature.

The term "sintering temperature" may particularly denote a temperature value or range at which densification of particles of the sinter material and/or diffusion of particles of the sinter material into adjacent surface layers may start. In particular, the sintering temperature may be (far) below the melting temperature of the sinter material.

The term "the sintering and the soldering are executed simultaneously" may particularly denote that method steps of a sequence of the soldering process and a sequence of the sintering process may at least partially overlap in time and/or may form part of a same process sequence. For example, (at least) a cooling step of the involved elements to be connected to another by soldering and sintering may be executed at a same time (instance).

According to the exemplary aspect of the invention, first and third elements of the plurality of elements may be connected to one another using a soldering process, thereby forming a solder layer between the first and third elements. Further, second and fourth elements of the plurality of elements may be connected to one another using a sintering process with the sintering process being executed simultaneously to the soldering process. A respective sinter layer may be formed by the sintering process between the second and fourth elements. Combining the soldering process and the sintering process in a same process sequence may be favourably accomplished by both processes requiring high temperatures.

Thus, in particular, a total process time of connecting the involved elements to one another using two different bonding techniques may be significantly low, since the sintering process and the soldering process may be simultaneously executed instead of being separately executed.

In particular, arising costs for connecting the involved elements to one another may be low, since a common equipment (for example, a common process chamber, a common process gas, a common vacuum equipment) may be used during the method.

In particular, in a case in which the method may be used during mass production of electronic devices, a throughput of the elements to be connected to one another may be high, since a total process time required for the connection of the involved elements to one another may be reduced.

Next, further exemplary embodiments of the method of connecting elements of a plurality of elements to one another will be described. However, these embodiments also apply to the electronic device manufactured by the method.

The liquidus temperature of the solder material may be equal to or above approximately the sintering temperature of the sinter material, and the method may further comprise applying pressure to the second and fourth elements, and heating the first, second, third, and fourth elements to at least approximately the liquidus temperature of the solder material. Thus, the sintering process and the soldering process may be executed during a common process sequence, since the highest required temperature for connecting the involved elements to one another may be provided. In particular, the sintering of the second and fourth elements may start at the sintering temperature, and may be even enhanced when further heating the second and fourth elements to the liquidus temperature of the solder material. In particular, the application of the pressure to the second and fourth elements may allow for sufficient densification of the sinter material particles and/or diffusion of the sinter material particles into adjacent surface layers of the second and fourth elements. In particular, the solder material may be melted at the liquidus temperature of the solder material such the solder material may flow over a surface portion of the first element and the third element for establishing the solder connection.

The liquidus temperature of the solder material may be below approximately the sintering temperature of the sinter material, and the method may further comprise applying pressure to the second and fourth elements, and heating the first, second, third, and fourth elements to approximately at least the sintering temperature of the sinter material. Accordingly, the involved elements may be exposed to the highest temperature required for the sintering and soldering process such that both processes may be executed in a common process sequence. In particular, the soldering of the first and third elements may start prior to the sintering of the second and fourth elements at a time instance when the liquidus temperature of the solder material may be reached.

A process atmosphere may comprise oxygen at least during the heating (particularly of the first, second, third, and fourth elements to at least the liquidus temperature of the solder material or the sintering temperature of the sinter material). Thus, the sintering process may be initiated by the oxygen in the process atmosphere when the sintering temperature of the sinter material may be reached.

In particular, the process atmosphere may comprise oxygen during a complete method sequence. In particular, the process atmosphere may comprise ambient air. Accordingly, the method may be facilitated, since no vacuum equipment may be required.

In particular, the process atmosphere may comprise vacuum, and oxygen may be added to the process atmosphere during the heating. The term "vacuum" may particularly denote a process atmosphere comprising a low pressure value which may be particularly below about 10 Millibar (mbar), particularly below about 1 mbar, further particularly below about 0.1 mbar.

In particular, an oxygen partial pressure of the process atmosphere may be adjusted, particularly increased, in order to improve the sinter process.

The solder material may comprise a flux agent and/or at least a portion of a surface of at least one of the first and third elements may comprise a metal, particularly a noble metal. The term "flux agent" may particularly denote any material suitable for allowing a metal amount of a solder material to flow when being liquefied. In particular, a flux agent may comprise a soldering flux. The term "noble metal" may particularly denote a metal which may be resistant to corrosion and/or oxidation in moist air, in contrast to most base metals. In particular, in a case in which the solder material may comprise the flux agent, the surface portion may be free of the metal, particularly the noble metal. In particular, in a case in which the surface portion may comprise the metal, particularly the noble metal, the solder material may be free of the flux agent. Since the solder material may comprise the flux agent, the flux agent may allow for breaking bonds or preventing a formation of bonds formed by ambient oxygen of the process atmosphere and the surface molecules of the first and third elements to be soldered together, and thus may remove or prevent surface oxides. Additionally or alternatively, by providing at least the surface portion of the first and/or third elements with a metal, for example, in the form of a coating layer, the respective surface portions of the first and/or third elements may withstand oxidation during the sintering process. Accordingly, a stable solder bonding layer having sufficient strength may be formed.

The solder material may be free of a flux agent and/or at least a portion of a surface of at least one of the first and third elements may be free of a metal, particularly a noble metal, wherein, in addition or alternatively to the latter, a process atmosphere may comprise vacuum, wherein the method may further comprise adding oxygen to the process atmosphere. In particular, in a case in which the solder material may be free of the flux agent, the surface portion may comprise the metal, particularly the noble metal. In particular, in a case in which the surface portion may be free of the metal, particularly the noble metal, the solder material may comprise the flux agent. In particular, since the adding of the oxygen may be executed subsequent to the heating of the first, second, third, and fourth elements to at least the liquidus temperature of the solder material or the sintering temperature of the sinter material, the solder material may liquefy prior to the adding of the oxygen to the process atmosphere. Thus, interfaces of the first and third elements may be prevented from oxidation prior to the soldering process such that a solder bond having sufficient strength may be accomplished between the first and third elements. Further, since the process atmosphere may comprise vacuum, a formation of solder voids in the formed solder bonding layer may be reduced or even prevented. Here, the term "solder void" may particularly denote a cavity formed in the solder bonding layer. Further, adding oxygen subsequent to the heating may allow for an easily controllable process sequence.

In particular, the adding of the oxygen may be executed prior to the heating of the first, second, third, and fourth elements to at least the sintering temperature of the solder material, particularly in a case in which the sintering temperature of the sinter material may be above the liquidus temperature of the solder material and/or the solder material may be free of a flux agent. Melting of the solder material may start prior to reaching the sintering temperature, and oxidation of interfaces between the solder material, the first element and the third element may be prevented. Here, the addition of the oxygen may be executed at a temperature above approximately the liquidus temperature of the solder material. Thus, a process sequence may be adapted to the characteristics of the solder material and the sinter material such that time duration and costs for providing the vacuum atmosphere may be reduced.

The applying of the pressure may be executed prior to (and during) the heating (particularly of the first, second, third, and fourth elements to approximately at least the liquidus temperature of the solder material or the sintering temperature of the sinter material). Accordingly, the sintering process may start immediately when the respective sintering temperature of the sinter material may be reached and oxygen may be present in the process atmosphere. Thus, a natural and easy process sequence may be used for sintering the second and fourth elements to one another, thereby facilitating the method.

The applying of the pressure may be executed subsequent to the heating of the first, second, third, and fourth elements to at least approximately the sintering temperature of the sinter material. In particular, the latter measure may apply for cases in which the liquidus temperature of the solder material may be below the sintering temperature of the sinter material and/or the solder material may be free of the flux agent and oxygen may be added to the vacuum process atmosphere. In particular, the densification and/or diffusion of the sinter material particles may only start with the addition of the oxygen to the process atmosphere which may be executed prior or subsequent to the increasing of the temperature to at least the sintering temperature of the sinter material. Accordingly, the second and fourth elements may be exposed for a shorter duration to forces such that a stress of the material of the second and fourth elements and the sinter material may be minimized, thereby preventing damages of the second and fourth elements and enhancing a strength of the sinter bond.

The method may further comprise (particularly prior to the applying of the pressure and/or the heating of the involved elements to at least the sintering temperature of the sinter material) heating the first, second, third, and fourth elements to a liquefying temperature of the solder material which may be above approximately the liquidus temperature of the solder material and may be approximately below the sintering temperature of the sinter material. In particular, the latter measure may be executed in a case in which the liquidus temperature may be below the sintering temperature, the solder material may be free of a flux agent, and oxygen may be added to the vacuum process atmosphere. Thus, liquefying of the solder material may occur prior to the addition of the oxygen such that oxidation of the interfaces between the first and third elements and the solder material may be reduced or even prevented. A later formation of solder voids in the solder bond may also be reduced or prevented, since the solder material may liquefy at a low process pressure atmosphere allowing for a homogeneous distribution of the solder material over adjacent surface layers.

The method may further comprise heating (prior to the applying of the pressure and/or the heating to approximately the liquefying temperature and/or at least approximately the liquidus temperature of the solder material and/or the heating to at least approximately the sintering temperature of the sinter material) the first, second, third, and fourth elements to a drying temperature of the sinter material, wherein the drying temperature may be below the liquefying temperature and liquidus temperature of the solder material and the sintering temperature of the sinter material. Thus, a solvent or a water amount eventually present in the sinter material may be removed, whereby the strength of the formed sinter bond between the second and fourth elements may be significantly improved.

The assembling of the second and fourth elements (and/or the assembling of the first and third elements) may be executed prior or subsequent to the heating to at least approximately the drying temperature of the sinter material. A sequence of the latter measures may particularly depend on characteristics (for example, a viscosity) of the used sinter material and/or a size of the involved elements. In particular, in a case in which the sinter material may comprise a highly viscous form, it may be favourable to first assemble the second element including the applied sinter material and the fourth element, and afterwards to heat the second and fourth elements to the drying temperature of the sinter material. In particular, in a case in which the fourth element may comprise a small size compared to the second element, it may be favourable to first heat the involved elements to the drying temperature of the sinter material and afterwards to assemble the second element including the dried sinter material and the fourth element. Thus, the method may be facilitated.

The solder material may comprise (or may be configured) as a solder paste or a solder perform (particularly a solid plate). In particular, the solder paste may comprise a flux agent, and the solder preform may be free of a flux agent. In particular, using a solder paste may allow for easily applying the solder material to the first element, since the solder paste may be formable to match a surface shape of the second element. In particular, usage of the solder preform may allow for facilitating the handling of the solder material during the assembling of the solder perform and the first and third elements, since the solder preform may comprise a stable, not deformable shape.

In particular, the solder material may comprise at least one of lead, tin, silver, and copper. In particular, the solder material may comprise an alloy based on at least one of the latter materials. Thus, conventional and cost-effective solder materials may be employed, thereby further decreasing costs required for executing the method.

The sinter material may comprise (or may be configured) as a sinter paste. In particular, the sinter paste may allow for easily applying the sinter material to the second element, since the sinter paste may be formable to match a surface shape of the second element.

In particular, the sinter material may comprise a metal, particularly silver, and/or a metal alloy.

The sinter material may comprise metal particles of micrometer scale. In particular, the term "particle of micrometer scale" may particularly denote particles which may comprise a size or diameter which is less than 500 Micrometer (µm) and favourably less than 100 µm.

At least one of the first and second elements and the third and fourth elements may be integrally formed. Thus, the method may be usable for connecting (at least) two elements to one another via a sintering bond and a solder bond, and may be particularly usable to connect three elements to one another. In the latter case, a first element and a second element may be soldered to one another and the first element and a third element may be sintered to one another.

In particular, at least a portion of a (particularly outermost) surface of at least one of the first, second, third, and fourth elements may comprise (or may be made of or may consist of) a metal, particularly a noble metal. The following may also apply to the description of the first and third elements comprising the metal detailed in conjunction with the process atmosphere. In particular, the entire surface of at least one of the first, second, third, and fourth elements may comprise the metal, particularly the noble metal. In particular, at least one of the first, second, third, and fourth elements may comprise the metal, particularly the noble metal, in a bulk portion beneath the surface portion or may be made completely of the metal, particularly the noble metal. Accordingly, by providing at least the surface portion with the metal, particularly the noble metal, surface oxides forming on the surface portion may be reduced or even prevented, since dangling bonds of surface atoms or molecules of the surface portion may not undergo a reaction with oxygen present in the ambient atmosphere of the surface portion. The latter effect may be even enhanced for the noble metal. In particular, using a (noble) metal surface of at least the surface portion may be favourable in connection with executing the sintering process of the second and fourth elements, since the sintering process may require oxygen for its execution which may adhere to the surface portion of the first, second, third and fourth elements. Thus, a bond strength of the solder bond and the sinter bond between the involved elements may be significantly enhanced.

In particular, at least the surface portion of at least one of the second and fourth elements to be sintered together may comprise (or may be made of or may consist of) the metal, particularly the noble metal, since during the sintering process oxygen may be present in the process atmosphere which may eventually form surface oxides of the surface portions being free of the metal.

In particular, the surface portion comprising the (noble) metal (as described in the latter and/or with reference to the process atmosphere) may be manufactured by electroplating of a (noble) metal material.

In particular, the noble metal may be silver and/or gold.

In particular, at least one of the first, second, third and fourth elements may be configured as a substrate, a printed circuit board, a semiconductor chip, a diode chip, or a semiconductor die such that the method may be usable during electronic packaging.

In particular, the method steps may be executed until a change in a respective process condition may be executed. For example, the heating to a particular temperature may be executed and the particular temperature may be maintained (by further heating).

In particular, the heating may be executed in that an ambient temperature to which the involved elements may be exposed may be increased until a desired temperature may be reached.

In particular, the heating may be executed in that the involved elements may be heated for example by heating plates attached to surfaces of the involved components.

In particular, an upper temperature limit when heating the involved elements may be a temperature at which evaporation of the material of the involved elements, the sinter material and/or solder material may occur.

In particular, a liquidus temperature of the solder material may be about 280°C and a sintering temperature of the sinter material may be between at least about 250°C and at most about 300°C. The term "at least" may particularly denote a mathematical notation z", and the term "at most" may particularly denote the mathematical notation "<_".

In particular, a liquidus temperature of the solder material may be about 180°C and a sintering temperature of the sinter material may be between at least about 250°C and at most about 300°C. In particular, a liquefying temperature of the solder material may be about 200°C.

In particular, the first, second, third, and fourth elements may be heated to between at least about 280°C and at most about 350°C.

In particular, a drying temperature of the sinter material may be about 150°C.

In particular, a pressure to be applied to the second and fourth elements may be between at least about 3 Mega Pascal (MPa) and at most about 50 MPa, particularly between at least about 5 MPa and at most about 10 MPa or between at least about 30 MPa and at most about 40 MPa.

### Brief description of drawings

The invention will be described in more detail hereinafter with reference to examples of embodiment, but to which the invention is not limited.

Figs. 1 to 4 show perspective views of steps of a method of connecting elements of a plurality of elements to one another according to an exemplary embodiment of the invention.

Fig. 5 illustrates an electronic device manufactured by a method of connecting elements of a plurality of elements to one another according to another exemplary embodiment of the invention.

### Description of embodiments

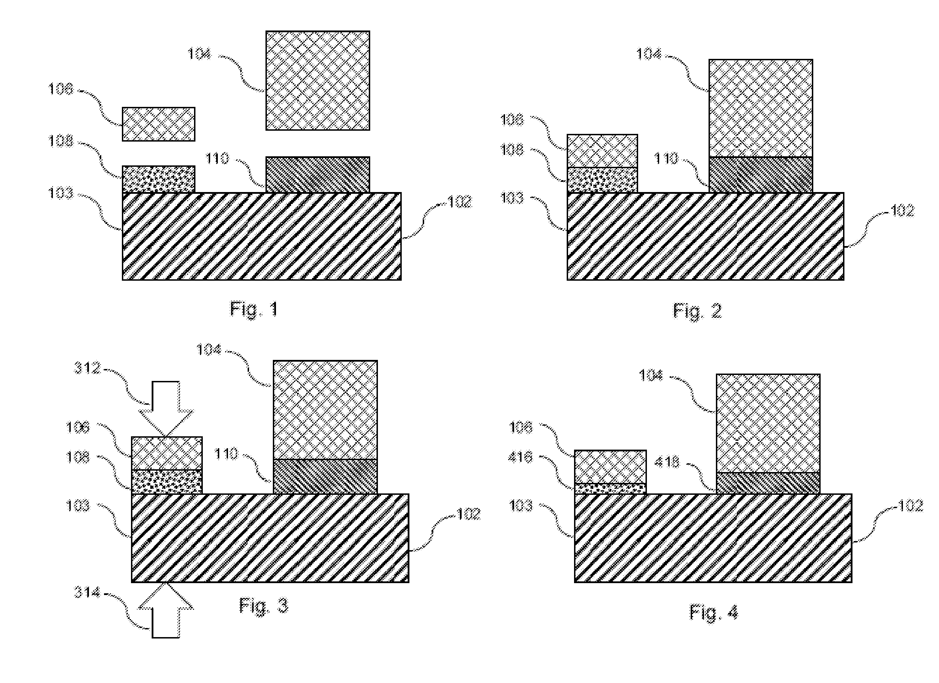

Referring to Figs. 1 to 4, a method of connecting elements of a plurality of elements to one another according to a first exemplary embodiment of the invention will be explained. The method is executed during electronic packaging and forms part of a method of manufacturing an electronic device. The connection between respective elements of the plurality of elements is based on soldering and low temperature bonding (LTB) which belongs to a pressure sintering technique.

A process atmosphere is ambient air comprising oxygen. An initial ambient temperature is room temperature.

In a first step, a first element 102, a second element 103, a third element 104, and a fourth element 106 are provided. The first element 102 and second element 103 are integrally formed and are configured as portions of a printed circuit board. For simplicity of reading, the printed circuit board is referenced in the following by the reference numeral 102. The third element 104 is configured as a conductor plate to be soldered to the printed circuit board 102. The fourth element 106 is configured as a semiconductor chip to be bonded to the printed circuit board 102 using a flip-chip technique.

Next, as illustrated in Fig. 1, a sinter material 108 in the form of a silver paste 108 comprising micrometer scale silver particles embedded in an epoxy is applied on an upper surface portion of the printed circuit board 102 via electroplating. A sinter temperature of the sinter material 108 is 250°C. A high melting tin solder paste 110 comprising a flux agent is applied on a surface of the second portion of the printed circuit board 102. A liquidus temperature of the solder paste 110 is 280°C, i.e. the liquidus temperature of the solder paste 110 is above the sintering temperature of the sinter paste 108.

Next, as illustrated in Fig. 2, the printed circuit board 102, the semiconductor chip 106 and the conductor plate 104 are assembled in that the semiconductor chip 106 is placed on the sinter paste 108, and the conductor plate 104 is placed on the solder paste 110. Next, an ambient temperature to which the printed circuit board 102, the semiconductor chip 106, the conductor plate 104, the sinter paste 108, and the solder paste 110 are exposed is increased to a drying temperature of the sinter paste 108 of 150°C such that the sinter paste 108 is dried and a possible water amount of the sinter paste 110 is removed.

Next, as illustrated in Fig. 3, mechanical pressure is applied to the upper surface of the conductor plate 104 and the lower surface of the printed circuit board 102. The application of the pressure is indicated by arrows 312, 314. A value of the applied pressure is 48 MPa.

Next, the ambient temperature is increased to 280°C such that the sintering process is initiated. Meanwhile, the solder paste 110 is liquefied when reaching the liquidus temperature of 280°C.

Next, the ambient temperature is decreased to room temperature, and the pressure applied to the semiconductor chip 106 and the printed circuit board 102 is released when the ambient temperature is again room temperature. During the cooling process, the solder paste 110 solidifies, thereby interconnecting the printed circuit board 102 and the conductor plate 104, and densification of the particles of the sinter paste 108 and diffusion of the particles of the sinter paste 108 into the surface layers of the printed circuit board 102 and the conductor plate 104 stops when the ambient temperature goes below the sintering temperature of 280°C.

Fig. 4 shows the printed circuit board 102, the semiconductor chip 106, and the conductor plate 104 bonded to one another. A sinter layer 416 is arranged between the semiconductor chip 106 and the printed circuit board 102, and a solder layer 418 is sandwiched between the conductor plate 104 and the printed circuit board 102.

Further, a sequence of the step of drying the sinter paste 108 and the step of assembling the semiconductor chip 106 on the printed circuit board 102 may be reversed.

Further, a process atmosphere may comprise vacuum to which oxygen may be added during the increasing of the temperature to the liquidus temperature of the solder material 110.

Further, an oxygen partial pressure may be increased with respect to ambient air, in order to enhance the sintering process.

In the following, a method of connecting elements of a plurality of elements to one another according to a second exemplary embodiment of the invention will be described with reference to Figs. 1- 4.

A used sinter material 108 is based on silver comprising micrometer scale particles and comprises a sintering temperature of 250°C. A tin-copper alloy based solder material 110 comprises a liquidus temperature of 280°C. Further, the solder material 110 is configured as a solder preform and is free of a flux agent. A process atmosphere comprises vacuum.

A process sequence is identical to a process sequence described with reference to Figs. 1 to 4. However, oxygen is added to the process atmosphere subsequent to the increasing of the ambient temperature to the liquidus temperature of the solder material 110 immediately at a time instance when the liquidus temperature is reached.

Since the process atmosphere comprises vacuum until the ambient temperature reaches the liquidus temperature, a formation of solder voids between the printed circuit board 102 and the electrical conductor 104 is prevented when the solder preform 110 is liquefied. Further, oxidation of interfaces between the solder perform 110, the conductor plate 104 and the printed circuit board 102 is prevented, since the solder preform 110 is liquefied and covers respective surface portions of the printed circuit board 102 and the conductor plate 104 before the oxygen is added to the process atmosphere.

Further, as no oxygen is present in the process atmosphere until the oxygen is added to the vacuum process atmosphere, the sintering process of the sinter paste 108 is not initiated despite the ambient temperature reaching the sintering temperature of 250°.

A sequence of the step of drying the sinter paste 108 and the step of assembling the semiconductor chip 106 on the printed circuit board 102 may be reversed.

Further, an oxygen partial pressure may be increased with respect to the process atmosphere comprising oxygen, in order to enhance the sintering process.

In the following, a method of connecting elements to one another according to a third exemplary embodiment of the invention will be described with reference to Figs. 1 to 4. A sinter material 108 is configured as a silver particle paste comprising a sintering temperature of 250°C. A solder material 110 is configured as a low melting tin paste with a liquidus temperature of 180°C. Further, the solder paste 110 comprises particles of micrometer scale embedded in an epoxy and a flux agent. A process atmosphere comprises ambient air.

A process sequence of the method is identical to a process sequence of the method according to the first exemplary embodiment described in Figs. 1 to 4.

However, since the liquidus temperature of the solder paste 110 is below the sintering temperature of the sinter paste 108, the solder paste 110 is liquified at the temperature of 180°C, whereas the sintering process is initiated when the ambient temperature reaches the sintering temperature of 280°C. Since the solder paste 110 comprises a flux agent, the flux agent of the solder paste removes oxides formed on the surfaces of the conductor plate 104, the printed circuit board 102, and the solder paste 110.

Further, a sequence of the step of drying the sinter paste 108 and the step of assembling the semiconductor chip 106 and the printed circuit board 102 may be reversed.

In the following, a method of connecting elements of a plurality of elements to one another according to a fourth exemplary embodiment of the invention will be explained with reference to Fig. 1 to 4.

A used sinter material 108 is configured as a silver paste comprising particles of micrometer scale embedded in an organic solvent. A solder material 110 is configured as a low melting solder perform 110 made of a tin copper alloy and comprises a liquidus temperature of 180°C. The solder preform 110 comprises no flux agent. An initial process atmosphere comprises vacuum.

A process sequence of the method is as follows. First, method steps according to the first exemplary embodiment illustrated in Figs. 1 and 2 are executed. Next, the ambient temperature is increased to a liquefying temperature of the solder perform 110 of 200°C, such that the solder preform 110 is liquefied. Here, a formation of solder voids is prevented owing to the vacuum process atmosphere.

Next, method steps illustrated in Fig. 3 are executed.

Next, oxygen is added to the process atmosphere such that the sintering process is initiated. Further, since the solder preform 110 has already been liquefied, oxidation of respective surfaces of the solder perform 110, the printed circuit board 102 and the electrical conductor 104 during the flowing of the solder perform 110 is prevented.

Afterwards, the ambient temperature is cooled down to room temperature, and the pressure applied to the semiconductor chip 106 and the printed circuit board 102 is released.

A sequence of method steps of assembling the semiconductor chip 106 and the printed circuit board 102 and of drying the sinter material 108 may be reversed.

Further, a sequence of the steps of applying pressure to the semiconductor chip 106 and the printed circuit board 102 and the step of increasing the ambient temperature to the sintering temperature of the sinter material 108 may be reversed.

Further, a sequence of the steps of increasing the ambient temperature to the sintering temperature and the step of adding oxygen to the process atmosphere may be reversed.

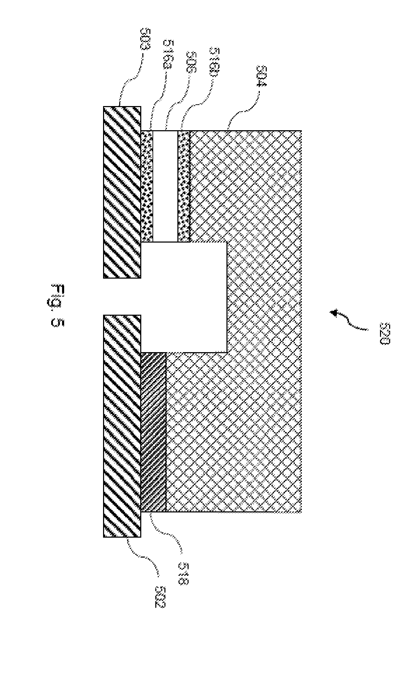

Referring to Fig. 5, an electronic device manufactured by a method of connecting elements of a plurality of elements to one another according to a fifth exemplary embodiment of the invention will be explained.

The electronic device 520 comprises a first element 502 configured as a carrier, a second element 503 configured as a chip carrier and being electrically insulated from the carrier 502, a third element 504 configured as an electrical conductor, and a fourth element 506 configured as a semiconductor die. The chip carrier 503 is connected to the semiconductor die 506 via a first sinter layer 516a, and the semiconductor die 506 is connected to a first portion of the electrical conductor 504 via a second sinter layer 516b. The carrier 502 is connected to a second portion of the electrical conductor 504 via a solder layer 518.

The sinter layers 516a, b and the solder layer 518 are generated in that a sinter material is applied on an upper surface of the semiconductor die 506, the semiconductor die 506 is assembled on the chip carrier 503, and identical sinter material is applied on a top surface of the semiconductor die 506. Next, a solder material is applied on the carrier 502. Next, the first and second portions of the electrical conductor 504 are assembled on the semiconductor die 506 and the carrier 502, respectively. A following method sequence is identical to the method sequence of the method according to the second exemplary embodiment. Respective specifications of the solder material, the sinter material, a process atmosphere and heating temperatures also apply to this method.

### Reference signs list

- 102, 502: first element
- 103, 503: second element
- 104, 504: third element
- 106, 506: fourth element

- 108: sinter material
- 110: solder material
- 312,314: arrows
- 416, 516a, b: sinter layer
- 418, 518: solder layer
- 520: electronic device

## Claims

1. A method of connecting elements (102-106, 502-506) of a plurality of elements (102-106, 502-506) to one another, the method comprising:
- applying solder material (110) on a first element (102, 502) of the plurality of elements (102-106, 502-506), wherein the solder material (110) comprises a liquidus temperature,
- applying sinter material (108) on a second element (103, 503) of the plurality of elements (102-106, 502-506), wherein the sinter material (108) comprises a sintering temperature,
- assembling the first element (102, 502) and a third element (104, 504) of the plurality of elements (102-106, 502-506),
- assembling the second element (103, 503) and a fourth element (106, 506) of the plurality of elements (102-106, 502-506),
- soldering the first element (102) and the third element (104, 504) to one another, and
- sintering the second element (103, 503) and the fourth element (106, 506 ) to one another,
wherein the sintering and the soldering are simultaneously executed.

2. The method according to claim 1, wherein the liquidus temperature of the solder material (110) is equal to or above the sintering temperature of the sinter material (108), the method further comprising:
- applying pressure to the second and fourth elements (103, 106, 503, 506), and
- heating the first, second, third, and fourth elements (102-106, 502-506) to at least the liquidus temperature of the solder material (110).

3. The method according to claim 1, wherein the liquidus temperature of the solder material (110) is below the sintering temperature of the sinter material (108), the method further comprising:
- applying pressure to the second and fourth elements (103, 104, 503, 506), and
- heating the first, second, third, and fourth elements (102-106, 502-506) to at least the sintering temperature of the sinter material (108).

4. The method according to anyone of claims 1 to 3, wherein a process atmosphere comprises oxygen at least during the heating.

5. The method according to anyone of claims 1 to 4, wherein the solder material (110) comprises a flux agent and/or wherein at least a portion of a surface of at least one of the first and third elements (102, 104, 502, 504) comprises a noble metal.

6. The method according to anyone of claims 1 to 3, wherein the solder material (110) is free of a flux agent, wherein a process atmosphere comprises vacuum, the method further comprising:
- adding oxygen to the process atmosphere subsequent to the heating.

7. The method according to anyone of claims 2 to 6, wherein the applying of the pressure is executed prior to the heating.

8. The method according to claim 3 or 6, wherein the applying of the pressure is executed subsequent to the heating of the first, second, third, and fourth elements (102-106, 502-506) to at least the sintering temperature of the sinter material (108).

9. The method according to anyone of claims 1, 3, 6, 7 or 8, the method further comprising:
- heating the first, second, third, and fourth elements (102-106, 502-506) to a liquefying temperature of the solder material (110) which is above the liquidus temperature of the solder material (110) and is below the sintering temperature of the sinter material (108).

10. The method according to anyone of claims 2 to 9, the method further comprising:
- heating, prior to the applying of the pressure, the first, second, third, and fourth elements (102-106, 502-506) to a drying temperature of the sinter material (108), wherein the drying temperature is below the liquidus temperature of the solder material (110) and the sintering temperature of the sinter material (108).

11. The method according to claim 10, wherein the assembling of the second and fourth elements (103,106, 503, 506) is executed prior or subsequent to the heating to the drying temperature of the sinter material (108).

12. The method according to anyone of claim 1 to 11, wherein the solder material (110) comprises a solder paste or a solder perform.

13. The method according to anyone of claim 1 to 12, wherein the sinter material (108) comprises a sinter paste.

14. The method according to anyone of claims 1 to 13, wherein the sinter material (108) comprises metal particles of micrometer scale.

15. The method according to anyone of claims 1 to 14, wherein at least one of the first and second elements (102, 103, 502, 503) and the third and fourth elements (104, 106, 504, 506) are integrally formed.
